# EUROPEAN PATENT APPLICATION

(11) **EP 4 312 078 A1**
(43) Date of publication of application: **31.01.2024**
(21) Application number: 22187852.3
(22) Date of filing: 29.07.2022
(51) Int. Cl.: G03F 7/20, G03F 9/00

(54) **CONTAMINATION DETERMINATION**

(71) Applicant: ASML Netherlands B.V., 5500 AH Veldhoven (NL)
(72) Inventor: DREISSEN, Mante, 5500 AH Veldhoven (NL); DUIVENVOORDEN, Kasper Hendrikus, 5500 AH Veldhoven (NL); CARBONE, Ludovico, 5500 AH Veldhoven (NL); SKOULIDOU, Dimitra, 5500 AH Veldhoven (NL); LEVASIER, Leon Martin, 5500 AH Veldhoven (NL); VAN AERLE, Nicolaas Aldegonda Jan Maria, 5500 AH Veldhoven (NL)
(74) Representative: ASML Netherlands B.V.

(57) **Abstract**

A method of determining contamination of an optical sensor of a sensing system in a lithographic apparatus, the method comprising directing EUV radiation through an opening in a reticle masking blade and onto a patterning device, projecting reflected EUV radiation onto the sensing system and thereby causing build-up of an area of contamination, measuring a height of the area of contamination and a height of an area of the sensing system which did not receive the reflected EUV radiation, and using the measured heights to determine an amount of contamination on the optical sensor of the sensing system.

## Description

### FIELD

The present invention relates to determining contamination of an optical sensor of a sensing system which forms part of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

When a lithographic substrate is being exposed it is supported by a substrate table. The substrate table may comprise a substrate clamp and a base which holds the substrate clamp. The base may comprise reflective surfaces which allow for interferometric measurement of the position of the substrate table. Over time, contamination may build up on the substrate table. In particular, contamination may build up on areas of the substrate table which are not covered by a substrate during lithographic exposure. The substrate table is provided with a sensor system. The sensor system may be provided in the substrate table base (e.g. radially outward of the substrate clamp). When contamination builds up on a sensor of the sensor system this may have a detrimental effect upon the performance of sensor. The substrate table may be cleaned, for example using hydrogen radicals. However, such cleaning takes time, and exposure of lithographic substrates is suspended during cleaning. For this reason it is desirable not to clean the substrate table too often. Conversely however, if cleaning is delayed for too long then the build-up of contamination on the sensors may cause the performance of the lithographic apparatus to deteriorate outside of desirable parameters.

It may be desirable to provide a method and apparatus that overcomes or mitigates one or more problems associated with the prior art.

### SUMMARY

According to a first aspect of the present invention, there is provided a method of determining contamination of an optical sensor of a sensing system in a lithographic apparatus, the method comprising directing EUV radiation through an opening in a reticle masking blade and onto a patterning device, projecting reflected EUV radiation onto the sensing system and thereby causing build-up of an area of contamination, measuring a height of the area of contamination and a height of an area of the sensing system which did not receive the reflected EUV radiation, and using the measured heights to determine an amount of contamination on the optical sensor of the sensing system.

Embodiments of the invention advantageously allow an amount of contamination to be determined via a measurement, instead of merely estimating an amount of contamination. Because a measurement is used and not an estimate, cleaning of the optical sensor can be performed when cleaning is actually required (instead of cleaning when an estimate indicates that cleaning might be required).

The EUV radiation may be directed through multiple openings in the reticle masking blade. The heights of multiple areas of contamination may be measured.

The EUV radiation may be directed onto one or more alignment marks provided on the patterning device.

The EUV radiation may be directed onto one or more areas of the patterning device which are less than 50% covered by an absorber.

The opening in the reticle masking blade may be a slot.

The measured height of the area of contamination may be compared with a modelled height.

The model may be generated using the measured heights of areas which did not receive the reflected EUV radiation.

The model may comprise lines or curves which extend between the measured heights of areas which did not receive the reflected EUV radiation.

The optical sensor may be an imaging sensor.

According to a second aspect of the present invention, there is provided a lithographic apparatus comprising a patterning device support structure, reticle masking blades, a projection system, a level sensor, and a substrate table provided with a sensor system comprising an optical sensor, wherein at least one opening is provided in the reticle masking blade, and wherein the level sensor is configured to measure a height of at least one contaminated area of the optical sensing system and at least one uncontaminated area of the optical sensing system, and a processor configured to determine a height of the at least one contaminated area of the optical sensing system, and thereby determine an amount of contamination on the optical sensor.

A plurality of openings may be provided EUV in the reticle masking blade.

The one or more openings in the reticle masking blade may be slots.

The optical sensor may be an imaging sensor.

The processor may be configured to use a model to determine heights of peaks or dips caused by the contamination.

The model may be generated using measured heights of multiple uncontaminated areas of the optical sensing system.

According to a third aspect of the invention, there is provided a computer-readable storage medium comprising instructions which, when executed by a processor of a computing device cause the computing device to perform the method of the first aspect of the invention.

According to a fourth aspect of the invention, there is provided a computing device comprising a processor and memory, the memory storing instructions which, when executed by the processor cause the computing device to perform the method of the first aspect.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and a radiation source;
- Figure 2 depicts a reticle masking blade system which may be used by embodiments of the invention;
- Figure 3 schematically depicts use of a sensor system of the lithographic apparatus;
- Figure 4 schematically depicts build-up of contamination on a sensor system of the lithographic apparatus;
- Figure 5A depicts a height measurement of non-contaminated areas together with modelled heights according to an embodiment of the invention;
- Figure 5B depicts a height measurement of contaminated and non-contaminated areas together with modelled heights according to an embodiment of the invention a; and
- Figures 6 depicts the result of subtracting the height measurement of Figure 5A from the height measurement of Figure 5B according to an embodiment of the invention

### DETAILED DESCRIPTION

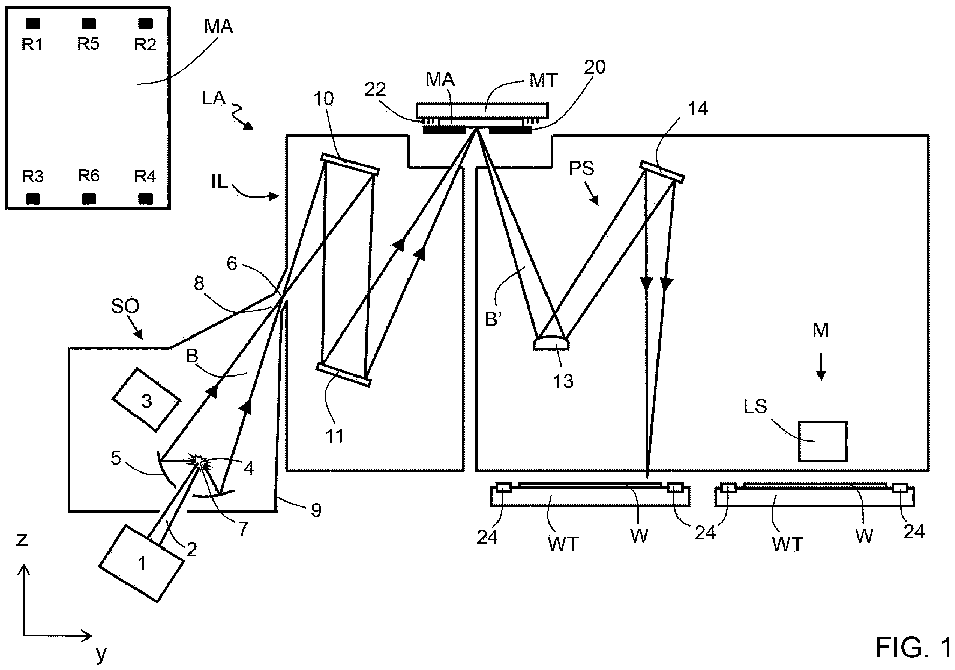

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

A reticle masking blade system 20 is used to selectively cover areas of the patterning device MA, such that only a desired portion of the patterning device receives EUV radiation at any given time. During a scanning exposure, the patterning device MA and support structure MT move in the y-direction, and the substrate W and substrate table WT move in the opposite y-direction. In this way, a band of EUV radiation passes over an exposure field on the substrate W.

The lithographic apparatus may be a dual-stage lithographic apparatus (as depicted). In a dual stage lithographic apparatus, properties of the substrate W are measured in a dedicated measurement area M. The substrate is supported by a substrate table WT during the measurement (there are two substrate tables WT in the lithographic apparatus). The measurement may comprise a measurement of the topography (height profile) of the substrate W performed using a level sensor LS, and measurements of the positions of alignment marks on the substrate. In addition, the positions and topography (height profile) of alignment marks on the substrate table WT are also measured. This provides a measurement of the positions of the alignment marks on the substrate in a reference frame of the substrate table WT.

Once the measurements have been completed, the substrate table WT is then moved to a so called exposure position, beneath the projection system PS, where it is exposed by patterned EUV radiation. When the substrate table WT is in this position, the positions of alignment marks on the substrate table are measured with respect to the position of alignment marks on the patterning device MA. This is done using sensor systems 24 which include alignment marks. This alignment of the patterning device MA with respect to the substrate table WT allows the patterning device to be aligned with the substrate W. The patterning device MA may for example be provided with six alignment marks R1-R6 (each of which may comprise a set of gratings), as schematically depicted in Figure 1.

In addition, gratings 22 provided on the support structure MT are illuminated by the EUV beam B. The projection system PS forms an image of this grating 22 at the substrate table WT. An imaging sensor which forms part of the sensor system 24 provides an output which characterizes the image of the grating 22. This output allows the focal plane of the projection system PS to be determined accurately. This in turn allows positioning of the substrate W such that a projected image of the patterning device MA is in focus on the substrate.

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

Contamination will build up on sensors of the sensor system 24. In one example, contamination build up on an imaging sensor of the sensing system may cause the imaging sensor to provide an inaccurate output. This in turn may cause a projected pattern to be poorly focused at the substrate W (the substrate may be positioned erroneously with respect to the focal plane due to the inaccurate output provided from the imaging sensor). Embodiments of the invention address this issue.

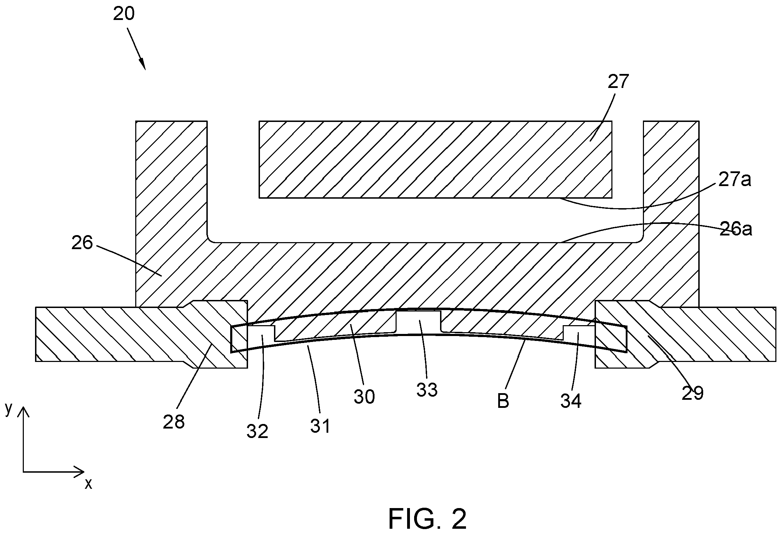

Figure 2 depicts a reticle masking blade system 20 which may be used by embodiments of the invention. The system 20 comprises a primary blade 26, a secondary blade 27, and two side-blades 28, 29. The primary blade 26 and secondary blade 27 are movable in the Y-direction. The side blades 28, 29 are movable in the X-direction.

During exposure of an exposure field of a substrate W, facing planar edges 26a, 27a of the primary and secondary blades 26, 27 are spaced apart from each other in the Y-direction to form a rectangular opening through which EUV radiation may pass. The side blades 28, 29 are used to form side walls of the rectangular opening, according to a desired X-direction size of the exposure field. In Figure 2, the side blades 28, 29 have a different position. This position is used during alignment measurements, as is explained below.

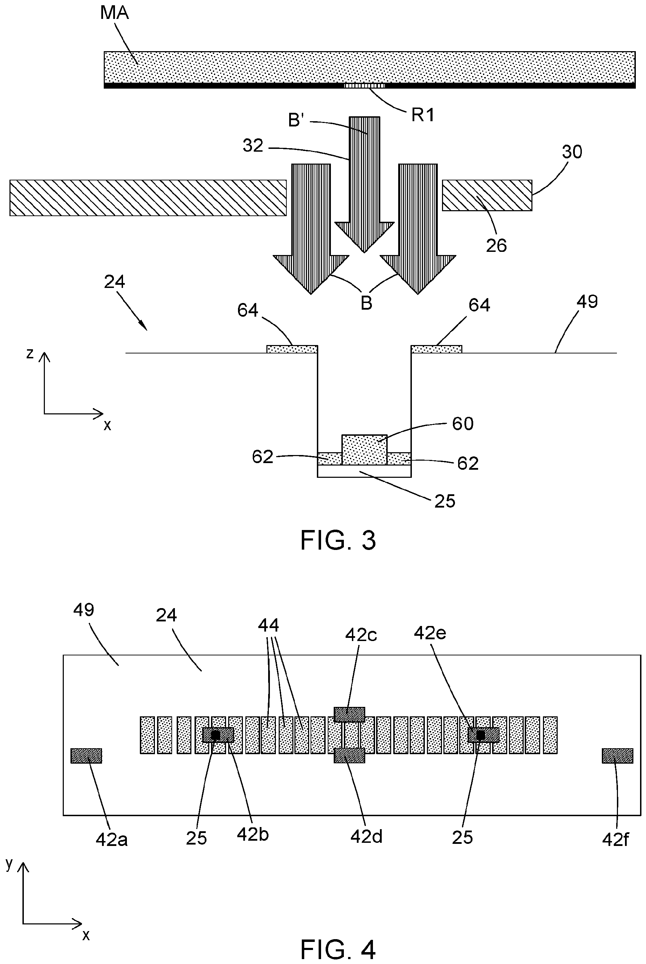

The EUV radiation beam B is also schematically depicted in Figure 3. During a lithographic exposure, the EUV radiation beam B is positioned between the facing planar edges 26a, 27a of the primary and secondary blades 26, 27. This controls the manner in which EUV radiation is incident upon the patterning device MA and upon the substrate WT.

During alignment measurements, the EUV radiation beam B is directed towards a different part 30 of the primary blade 26. This part 30 has a curved edge 31, with a curvature which corresponds to curvature in the XY plane of the EUV radiation beam B.

The primary blade 26 is provided with three generally rectangular slots 32-34. Each slot 32-34 extends inwardly with respect to the curved edge 31. Each slot 32-34 extends in the Y-direction by an amount which is greater than or equal to the Y-direction width of the EUV radiation beam B (as schematically depicted). The slots 32-34 may for example extend by between 4 mm and 6 mm in the Y-direction. The slots may for example extend in the X-direction by between 10 mm and 15 mm

During an alignment measurement, the EUV radiation beam B passes through the slots 32-34, is reflected by alignment marks 22 on the patterning device MA and is then incident upon sensor systems 24 on the substrate table WT. Other parts of the primary blade 26 block the EUV radiation beam such that it is not incident upon the patterning device MA and not incident upon the substrate table WT.

In this document the Y-direction is used to indicate a scanning-direction of the lithographic apparatus LA, and the X-direction is used to indicate a direction which is perpendicular to the scanning direction and which lies in a plane of the substrate table WT and/or the patterning device support structure MT.

Figure 3 in combination with Figures 1 and 2, schematically depicts alignment of the patterning device MA with respect to the substrate table WT. During operation of the lithographic apparatus LA, when it is desired to determine the position of the patterning device MA with respect to the substrate table WT, the alignment marks R1-R6 on the patterning device MA 22 are illuminated by the EUV radiation beam B (through the slots 32-34). Each depicted alignment mark R1-R6 may comprise at set of gratings, and may comprise other structures. This illumination is schematically depicted in Figure 3 for one alignment mark R1 (which is schematically depicted as a single grating). For ease of illustration only EUV radiation which has been reflected from the patterning device MA is depicted (i.e. radiation which is incident upon the patterning device is not depicted). As may be seen, the radiation is patterned by the alignment mark R1 and passes through one of the slots 32 provided in the primary reticle masking blade 26. Some radiation B is reflected by absorbing areas either side of the alignment mark R1 (the absorber does not fully absorb all radiation).

Radiation reflected from other alignment marks passes through the other slots (not depicted) provided in the primary reticle masking blade 26.

The sensing system 24 is provided on a substrate table. The sensing system 24 includes an imaging sensor 25, which may be recessed into a surface of the sensing system 24. The imaging sensor receives the patterned radiation B', and provides an output signal which allows alignment of the patterning device MA to be achieved with respect to the substrate table WT (and thus with respect to the substrate W). Radiation B which is reflected from the absorbing areas will be incident on an upper surface 49 of the sensing system 24.

Contamination will build up on the imaging sensor 25 and also on the upper surface 49 of the sensing system 24 (either side of the recess in which the imaging sensor is provided). In Figure 3 the contamination which builds up due to the reflected patterned radiation B' is shown as a central contamination area 60. The contamination which builds up due to the radiation B reflected from the absorbing areas is shown as peripheral contamination areas 62, 64. A first peripheral contamination area 62 is on the imaging sensor 25, and surrounds the central contamination area. A further peripheral contamination area 64 is on the upper surface 49 of the sensing system and surrounds the recess within which the imaging sensor 25 is provided. Figure 3 is schematic. In practice, the area of the peripheral contamination 64 on the upper surface 49 of the sensing system 24 is much greater than the area of the contamination 60, 62 in the recess. It is the thickness of the peripheral contamination on the upper surface 49 of the sensing system 24 that is measured by embodiments of the invention.

EUV radiation will pass through each of the slots 32-34 in the primary reticle masking blade 26 during alignment measurements. Alignment measurements may be performed simultaneously for two alignment marks using two imaging sensors. In some instances, EUV radiation which passes through at least one of the slots 32-34 is not incident upon an imaging sensor, but instead is incident on a part of the sensing system 24 which does not include an imaging sensor (or other optical sensor). The EUV radiation may be incident upon an upper surface of the sensing system 24.

As depicted in Figure 2, during measurements which use the imaging sensors 24, the primary reticle masking blade 26 is positioned such that the EUV radiation beam B only passes through the slots 32-34. EUV radiation at other positions is blocked by the primary reticle masking blade 26. The EUV radiation which passes through the slots 32-34 will cause a build-up of contamination on the imaging sensor system. This contamination arises due to interactions between the EUV radiation and molecules present in the vicinity of the substrate table WT. Thus, contamination such as carbon (and other materials) will build up at areas upon which the EUV radiation is incident.

Figure 4 schematically depicts the sensor system 24 viewed from above. The imaging sensors 25, which are depicted as black squares, occupy only a small proportion of the area of the sensor system 24. Areas where contamination build up occurs are indicated as grey blocks 42a-f. As noted further above, when contamination builds up in the imaging sensors 25 this will have a detrimental impact upon the performance of the imaging sensors.

According to an embodiment of the invention, the build-up of contamination on the imaging sensors 25 is determined by measuring a profile of contamination across an upper surface of the sensor system 24. The profile is measured using the level sensor LS (see Figure 1). The level sensor LS may for example be as described in US8842293, which is herein incorporated by reference.

The level sensor is configured to project a set of beams of radiation which illuminate areas 44 (some of which are labelled in Figure 4). The illuminated areas 44 may be rectangular, and may be provided in a row as depicted. Other arrangements may be used.

The substrate table WT is positioned such that illuminated areas 44 formed by the level sensor LS are incident upon r part of the surface of the sensor system 24. In the depicted embodiment, some of the illuminated areas 44 are areas where contamination build up is not expected, and other illuminated areas 44 correspond with four areas 42b-e where it is known that a build-up of contamination will occur. For each illuminated area 44, the level sensor LS provides a height measurement as an output. The height measurements from the level sensor LS for illuminated areas 44 that are not contaminated may be used to measure the height in the Z-direction of the sensor system 24. The measured heights may be compared with previously measured calibration heights. The result of this comparison may be used to adjust the height of the substrate table WT during lithographic exposures.

The outputs from the level sensor LS for illuminated areas 44 that include contamination 42b-e may be used to determine contamination of the imaging sensors 24.

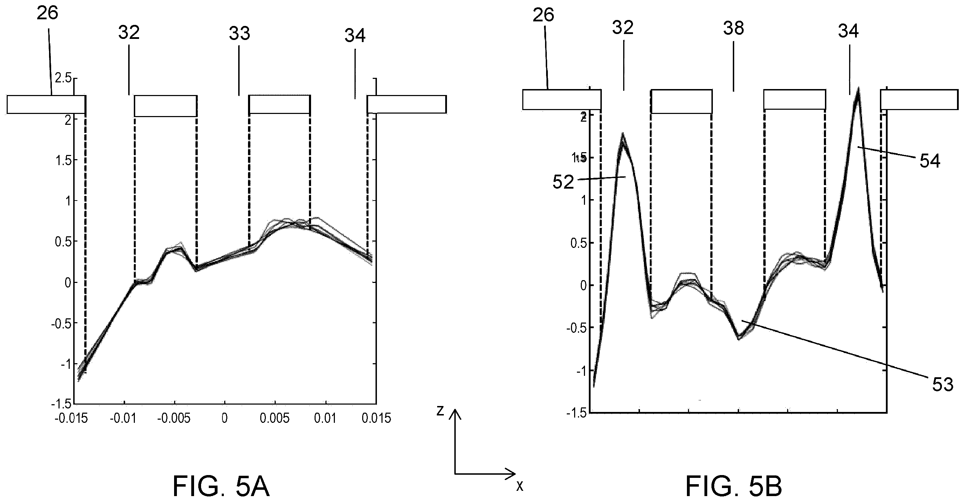

Figures 5A and 5B depict measurements of the height of the sensor system 24 as obtained by the level sensor LS. Also shown in Figures 5A and 5B are the X-direction positions of the slots 32-34 provided in the primary reticle blade 26. The measurements may be performed by the level sensor LS using multiple wavelengths of light. This is why multiple measurement lines are shown in Figures 5A and 5B.

In Figure 5A the output of the level sensor LS as used to measure non-contaminated areas is depicted. These areas are non-contaminated because they do not receive EUV radiation (they are in the shadow of the primary reticle blade 26). In Figure 5A measurements of the height of areas which receive contamination are not depicted. Instead, the heights of areas which receive contamination are modelled.

The upper surface of the sensor system 24 has a significant height variation, typically of the order of 1 µm. This height variation is measured as an initial calibration measurement to obtain a reference shape. The reference shape is subtracted from subsequent height measurements, so that the difference of the height of the sensor system compared with the reference shape is obtained. This difference typically has a range of the order of nanometers or tens of nanometers. The measured height of the non-contaminated areas of the sensor system, after subtraction of the reference shape, is what is depicted in Figure 5A.

Height values for the contaminated areas are generated using a model. In the embodiment depicted in Figure 5A, the model comprises straight lines which extend between measured height values (which may be referred to as linear interpolation). In other embodiments a more complex model may be used. For example, polynomial curves which extend between measured height values may be used. The polynomial curves may correspond with the reference shape of the upper surface of the sensor system 24.

In other embodiments, a linear interpolation model may be combined with measurements obtained after the sensor system 24 has been cleaned (e.g. using a weighted combination of the linear interpolation and measured values). In general, the model may take into account measurements obtained after the sensor system 24 has been cleaned.

As can be seen, in Figure 5A there is a variation of the height of around 2 nm. The value 0 nm on the vertical axis of Figure 5A does not have a particular significance - it is the range of height values that is important.

Figure 5B depicts the result of the level sensor measurement of the height of the sensor system 24, including contaminated areas (i.e. areas that have received EUV radiation). Due to the effect of contamination, the measured height of the sensor system 24 includes two peaks and a dip.

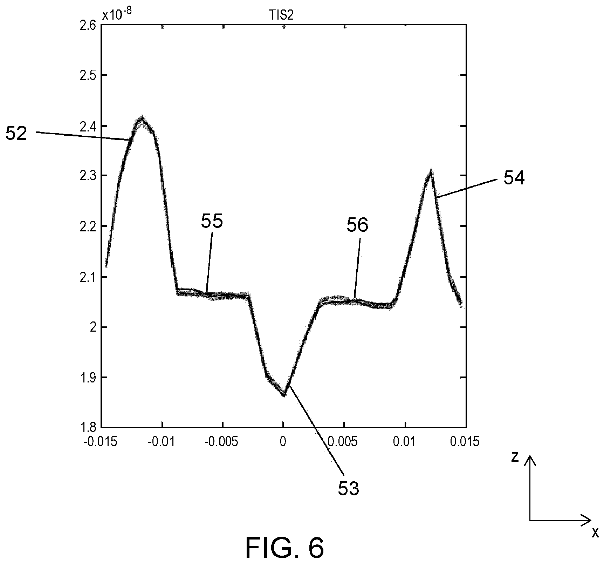

Figure 6 depicts the result of subtracting the height values of Figure 5A from the height values of Figure 5B. As may be seen, the result is two peaks 52, 54 and a dip 53, the peaks being connected to the dip with generally flat portions 55, 56.

The first peak 52 is at a position which corresponds with the first opening 32 of the reticle masking blade 26. It has a height of around 3 nm. The second peak 54 is at a position which corresponds with the third opening 34 of the reticle masking blade 26. This peak has a height of around 2.5 nm.

The dip 53 at the centre of Figure 6, corresponds with the second opening 33 of the reticle masking blade 26. This dip 53 is an artefact caused by the Y-direction positions of the contamination on the sensor system 24. As can be seen in Figure 4, the illuminated areas 44 overlap at an upper end with an area of contamination 42c and at a lower end with a different area of contamination 42d. This level sensor output is sensitive to the Y-direction offsets of the contamination 42c,d and this is why a dip is seen rather than a peak. However, the dip indicates the presence of contamination. That is, contamination is identified because the measured height has deviated from the modelled height (shown in Figure 5A).

The sizes of the peaks 52, 54 and the dip 53 may be used to determine the amount of contamination present on the sensor system 24.

The level sensor LS may be used to periodically determine the height of areas of the image sensing system 40 which receive contamination. As may be seen from Figure 4, areas of the sensor system 24 which do not receive EUV radiation experience little or no build-up of contamination. Thus, peaks and/or dips of measured height are established which are separated by areas without contamination. This configuration of contamination is suited to measurement by the level sensor LS, and thus allows the build-up of contamination to be measured. That is, the presence of peaks and/or dips can be determined. The sizes of the peaks and/or dips are indicative of the amount of contamination on the sensor system 24.

When the build-up of contamination on the sensor system 24 reaches a pre-determined level, cleaning of the sensor system 24 (and optionally other sensing systems of the substrate table WT) may be performed. The cleaning may be performed using a hydrogen radical generator.

In one example, cleaning may be performed when the measured height of one of the peaks exceeds 2nm (or a different value). In another example, cleaning may be performed when the average height of the peaks and the magnitude of the dip (i.e. the size of the dip but corrected for the negative sign of the dip) exceeds 2nm (or a different value). In general, cleaning may be performed when the height of one or more peaks or dips exceeds a predetermined threshold.

As depicted in Figure 3, contamination 60, 62 may be incident upon the imaging sensor 25 of the sensor system 24, and contamination 64 may also be incident on an upper surface 49 of the sensor system. The thickness of contamination received by a central area of the imaging sensor 25 may be greater than the thickness of contamination received by the upper surface 49 of the sensor system 24 (see Figure 3). A calibration may be used to determine a relationship between the thickness of contamination on the upper surface 49 of the sensor system 24 and the thickness of contamination on the imaging sensor 25. This may be taken into account when determining whether to clean the imaging sensor system.

In an embodiment, the height of the contaminated sensor system 24 may be directly compared to a height measurement obtained after the sensor system 24 has been cleaned (i.e. before significant build-up of contamination and without using the model referred to further above). However, this may be less preferred because there may be some drift of the overall height of the sensor system 24.

In a further embodiment, a height measurement obtained after the sensor system 24 has been cleaned may be taken into account when generating the model height values for contaminated areas.

In an embodiment, areas of contamination may be formed on the surface of the imaging sensing system 40 without using patterning device alignment marks. For example, areas of the patterning device which are generally reflective may be illuminated by the EUV beam and used to form areas of contamination on the surface of the imaging sensing system 40. These areas may be separated from the imaging sensors 24 so that build-up of contamination on the imaging sensors is not caused. This illumination of the generally reflective areas of the patterning device may be performed each time a patterning device alignment is performed, or may be performed less often. Because a generally reflective area of the patterning device is used (e.g. less than 50% of the area is covered by an absorber), the contamination will build up more quickly than contamination caused by alignment marks (e.g. more than 50% of the area is covered by an absorber). Because the contamination builds up more quickly, it may be easier to measure. A calibration may be used to link the height of this contamination with the height of contamination on the image sensor 25. A disadvantage of this embodiment is that extra time is used to illuminate the generally reflective areas of the patterning device.

The depicted embodiment uses the level sensor to measure the height of four contaminated areas 42b-e using a single measurement. However, in other embodiments other combinations of contaminated areas may be measured.

In the depicted embodiment of the invention, slots are provided in the reticle masking blade. However, any form of opening may be provided (e.g. holes rather than slots). Although multiple slots are depicted, a single slot (or other opening) may be provided. Two slots (or other openings) may be provided. Other numbers of slots or other openings may be provided.

Although the embodiment is described in connection with a sensor system having imaging sensors, the invention may be used in connection with a sensor system having other optical sensors.

A method according to an embodiment of the invention may be performed by a computing device. The device may comprise a central processing unit ("CPU") to which is connected a memory. The method described herein may be implemented in code (software) stored on a memory comprising one or more storage media, and arranged for execution on a processor comprising on or more processing units. The storage media may be integrated into and/or separate from the CPU. The code, which may be referred to as instructions, is configured to be fetched from the memory and executed on the processor to perform operations in line with embodiments discussed herein. Alternatively it is not excluded that some or all of the functionality of the CPU is implemented in dedicated hardware circuitry, or configurable hardware circuitry like an FPGA.

The computing device may comprise an input configured to enable a user to input data into a software program running on the CPU. The input device may comprise a mouse, keyboard, touchscreen, microphone etc. The computing device may further comprises an output device configured to output results of measurements to a user.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Clauses

1. A method of determining contamination of an optical sensor of a sensing system in a lithographic apparatus, the method comprising:
   directing EUV radiation through an opening in a reticle masking blade and onto a patterning device; projecting reflected EUV radiation onto the sensing system and thereby causing build-up of an area of contamination;
   measuring a height of the area of contamination and a height of an area of the sensing system which did not receive the reflected EUV radiation; and
   using the measured heights to determine an amount of contamination on the optical sensor of the sensing system.
2. The method of clause 1, wherein the EUV radiation is directed through multiple openings in the reticle masking blade, and wherein the heights of multiple areas of contamination are measured.
3. The method of clause 1, or clause 2, wherein the EUV radiation is directed onto one or more alignment marks provided on the patterning device.
4. The method of clause 1 or clause 2, wherein the EUV radiation is directed onto one or more areas of the patterning device which are less than 50% covered by an absorber.
5. The method of clause 1, wherein the opening in the reticle masking blade is a slot.
6. The method of any preceding clause, wherein the measured height of the area of contamination is compared with a modelled height.
7. The method of clause 6, wherein the model is generated using the measured heights of areas which did not receive the reflected EUV radiation.
8. The method of clause 7, wherein the model comprises lines or curves which extend between the measured heights of areas which did not receive the reflected EUV radiation.
9. The method of clause 7, wherein the model takes into account measured heights of areas which did receive the reflected EUV radiation, the measured heights being obtained after cleaning of the sensing system.
10. The method of any preceding clause, wherein the optical sensor is an imaging sensor.
11. A lithographic apparatus comprising a patterning device support structure, reticle masking blades, a projection system, a level sensor, and a substrate table provided with a sensor system comprising an optical sensor; wherein
   at least one opening is provided in the reticle masking blade; and
   wherein the level sensor is configured to measure a height of at least one contaminated area of the optical sensing system and at least one uncontaminated area of the optical sensing system; and
   a processor configured to determine a height of the at least one contaminated area of the optical sensing system, and thereby determine an amount of contamination on the optical sensor.
12. The lithographic apparatus of clause 11, wherein a plurality of openings are provided EUV in the reticle masking blade.
13. The lithographic apparatus of clause 11, wherein the one or more openings in the reticle masking blade are slots.
14. The lithographic apparatus of any of clauses 11 to 13, wherein the optical sensor is an imaging sensor.
15. The lithographic apparatus of any of clauses 11 to 14, wherein the processor is configured to use a model to determine heights of peaks or dips caused by the contamination.
16. The lithographic apparatus of clause 15, wherein the model is generated using measured heights of multiple uncontaminated areas of the optical sensing system.
17. A computer-readable storage medium comprising instructions which, when executed by a processor of a computing device cause the computing device to perform the method of any of clauses 1 to 10.
18. A computing device comprising a processor and memory, the memory storing instructions which, when executed by the processor cause the computing device to perform the method of any of clauses 1 to 10.

## Claims

1. A method of determining contamination of an optical sensor of a sensing system in a lithographic apparatus, the method comprising:
directing EUV radiation through an opening in a reticle masking blade and onto a patterning device; projecting reflected EUV radiation onto the sensing system and thereby causing build-up of an area of contamination;
measuring a height of the area of contamination and a height of an area of the sensing system which did not receive the reflected EUV radiation; and
using the measured heights to determine an amount of contamination on the optical sensor of the sensing system.

2. The method of claim 1, wherein the EUV radiation is directed through multiple openings in the reticle masking blade, and wherein the heights of multiple areas of contamination are measured.

3. The method of claim 1, or claim 2, wherein the EUV radiation is directed onto one or more alignment marks provided on the patterning device.

4. The method of claim 1 or claim 2, wherein the EUV radiation is directed onto one or more areas of the patterning device which are less than 50% covered by an absorber.

5. The method of claim 1, wherein the opening in the reticle masking blade is a slot.

6. The method of any preceding claim, wherein the measured height of the area of contamination is compared with a modelled height, or/and wherein the optical sensor is an imaging sensor.

7. The method of claim 6, wherein the model is generated using the measured heights of areas which did not receive the reflected EUV radiation.

8. The method of claim 7, wherein the model comprises lines or curves which extend between the measured heights of areas which did not receive the reflected EUV radiation.

9. The method of claim 7, wherein the model takes into account measured heights of areas which did receive the reflected EUV radiation, the measured heights being obtained after cleaning of the sensing system.

10. A lithographic apparatus comprising a patterning device support structure, reticle masking blades, a projection system, a level sensor, and a substrate table provided with a sensing system comprising an optical sensor; wherein
at least one opening is provided in the reticle masking blade; and
wherein the level sensor is configured to measure a height of at least one contaminated area of the sensing system and at least one uncontaminated area of the sensing system; and
a processor configured to determine a height of the at least one contaminated area of the sensing system, and thereby determine an amount of contamination on the optical sensor.

11. The lithographic apparatus of claim 10, wherein a plurality of openings are provided EUV in the reticle masking blade.

12. The lithographic apparatus of claim 10, wherein the one or more openings in the reticle masking blade are slots.

13. The lithographic apparatus of any of claims 10 to 12, wherein the optical sensor is an imaging sensor, or/and
wherein the processor is configured to use a model to determine heights of peaks or dips caused by the contamination.

14. The lithographic apparatus of claim 13, wherein the model is generated using measured heights of multiple uncontaminated areas of the sensing system.

15. A system for determining an amount of contamination on an optical sensor for a lithographic apparatus, comprising:
a level sensor, a sensing system comprising the optical sensor, and a processor,
wherein the level sensor is configured to measure a height of at least one contaminated area of the sensing system and at least one uncontaminated area of the sensing system; and
a processor configured to determine a height of the at least one contaminated area of the sensing system, and thereby determine an amount of contamination on the optical sensor.
